# EUROPEAN PATENT SPECIFICATION

(11) **EP 3 493 338 B1**
(45) Date of publication and mention of the grant of the patent: **04.09.2024**
(21) Application number: 17833804.2
(22) Date of filing: 19.05.2017
(51) Int. Cl.: H01S 5/343

(54) **SEMICONDUCTOR LIGHT-EMITTING ELEMENT AND METHOD FOR MANUFACTURING SEMICONDUCTOR LIGHT-EMITTING ELEMENT**
LICHTEMITTIERENDES HALBLEITERELEMENT UND VERFAHREN ZUR HERSTELLUNG EINES LICHTEMITTIERENDEN HALBLEITERELEMENTS
ÉLÉMENT ÉLECTROLUMINESCENT SEMI-CONDUCTEUR ET PROCÉDÉ DE FABRICATION D'ÉLÉMENT ÉLECTROLUMINESCENT SEMI-CONDUCTEUR

(30) Priority: 26.07.2016 JP 2016146558
(43) Date of publication of application: 05.06.2019
(73) Proprietor: Sony Semiconductor Solutions Corporation, Atsugi-shi, Kanagawa 243-0014 (JP)
(72) Inventor: KADOWAKI, Yasuhiro, Kikuchi-gun Kumamoto 869-1102 (JP)
(74) Representative: MFG Patentanwälte Meyer-Wildhagen Meggle-Freund Gerhard PartG mbB
(86) International application number: PCT/JP2017/018846
(87) International publication number: WO 2018/020793

(56) References cited:
- JP-A- 2009 099 681
- JP-A- 2010 199 139
- JP-A- 2011 029 224
- JP-A- 2011 146 653
- JP-A- 2011 146 653
- JP-A- 2011 258 717
- JP-A- 2015 159 193
- JP-A- 2015 231 021
- US-A1- 2002 167 983
- US-A1- 2003 030 053
- US-A1- 2009 101 927
- US-A1- 2011 158 275
- US-A1- 2015 270 686

## Description

### Technical Field

The present disclosure relates to a semiconductor light-emitting element and a method of manufacturing the semiconductor light-emitting element.

### Background Art

In recent years, it has been expected that a semiconductor laser using a nitride semiconductor such as GaN, AlGaN, GaInN, for example, is applied as a light source for a high-density optical disk apparatus, a laser beam printer, a full-color display, etc.

An approach to perform scribing and cleaving after crystal-growing a semiconductor layer on a substrate has been proposed as a manufacturing process of this semiconductor laser (PTL 1, for example).
US 2003/030053 A1 discloses a wafer having an LD structure formed on a GaN-based substrate, cleavage guide grooves are formed in its surface by scribing from above the LD structure with a diamond needle. The LD structure includes n-GaN contact layer, n-AlGaN clad layer, n-GaN optical guide layer, InGaN multiple quantum well active layer, p-AlGaN evaporation prevention layer, p-GaN optical guide layer, p-AlGaN clad layer, p-GaN contact layer, SiO2 dielectric film, and p-electrodes.
US 2015/270686 A1 discloses a group III nitride semiconductor laser device. The semiconductor laser device comprises a laser structure including a support base of the group III nitride and first and second end facets for a laser cavity, and the first and second end facets intersect with an m-n plane defined by the m-axis of the group III nitride and an axis normal to a semipolar primary surface of the support base.
US 2009/101927 A1 discloses a method of manufacturing a semiconductor light emitting device employs a substrate formed by successively stacking an n-type semiconductor layered portion including an AlGaN layer, a light emitting layer containing In and a p-type semiconductor layered portion on a group III nitride semiconductor substrate having a larger lattice constant than AlGaN. This method includes the steps of selectively etching the substrate from the side of the p-type semiconductor layered portion along a cutting line to expose the AlGaN layer along the cutting line, forming a division guide groove along the cutting line on the exposed AlGaN layer, and dividing the substrate along the division guide groove.
US 2002/167983 A1 discloses a point emission type light emitting element that restricts the light emitting area within a sufficiently tiny region, the point emission type light emitting element is a light emitting element that has stripe ridge comprising an n-type layer, an active layer and a p-type layer that are formed from semiconductors on a substrate

### Citation List

### Patent Literature

PTL 1: Japanese Unexamined Patent Application Publication No. 2011-146653

### Summary of the Invention

With an approach of the foregoing PTL 1, however, end surfaces may not be formed perpendicularly, causing variation in a threshold current of each element. Moreover, the end surfaces not being formed perpendicularly reduce a substantial reflectance. Alternatively, guided wave loss occurs to deteriorate characteristics such as the threshold current and slope efficiency.

In a semiconductor light-emitting element that performs formation of the end surfaces, it is desirable to achieve the semiconductor light-emitting element and a method of manufacturing the semiconductor light-emitting element that allow for suppression of characteristic deterioration.

A semiconductor light-emitting element according to an embodiment of the present disclosure includes a stacking structure having a substrate and a semiconductor layer between a first surface and a second surface that face each other in order from a side on which the first surface is located, the substrate including a compound semiconductor, and the semiconductor layer being crystal-grown on the substrate and including a light-emitting region; a first depression formed on at least a portion of a first edge adjacent to the second surface of the stacking structure; and a second depression formed on a second edge extending along a thickness direction of the stacking structure, wherein the second depression is provided as a hole continuously formed from the first surface to the second surface of the stacking structure.

In the semiconductor light-emitting element according to the embodiment of the present disclosure, the stacking structure has the substrate including the compound semiconductor and the semiconductor layer including the light-emitting region in order from the side on which the first surface is located, and the first depression is formed on at least the portion of the first edge adjacent to the second surface. The second depression is formed on the second edge extending along the thickness direction of the stacking structure. Providing the first depression and the second depression makes it easy to secure perpendicularity of an end surface.

A method of manufacturing a semiconductor light-emitting element according to an embodiment of the present disclosure includes: forming a stacking structure having a substrate and a semiconductor layer between a first surface and a second surface that face each other in order from a side on which the first surface is located, the substrate including a compound semiconductor, and the semiconductor layer being crystal-grown on the substrate and including a light-emitting region, the forming of the stacking structure including forming a first depression on at least a portion of a first edge adjacent to the second surface of the stacking structure, and forming a second depression on a second edge extending along a thickness direction of the stacking structure.

In the method of manufacturing the semiconductor light-emitting element according to the embodiment of the present disclosure, in the forming of the stacking structure having the substrate including the compound semiconductor and the semiconductor layer including the light-emitting region in order from the side on which the first surface is located, the first depression is formed on at least the portion of the first edge adjacent to the second surface and the second depression is formed on the second edge extending along the thickness direction of the stacking structure. Forming the first and second depressions makes it easy to secure perpendicularity of an end surface.

In the semiconductor light-emitting element according to the embodiment of the disclosure, the stacking structure has the substrate including the compound semiconductor and the semiconductor layer including the light-emitting region in order from the side on which the first surface is located, and the first depression is formed on at least the portion of the first edge adjacent to the second surface. The second depression is formed on the second edge extending along the thickness direction of the stacking structure. Providing the first and second depressions makes it possible to secure perpendicularity of the end surface and suppress deterioration in a threshold current, slope efficiency, etc. Therefore, it is possible to suppress characteristic deterioration.

In the method of manufacturing the semiconductor light-emitting element according to the embodiment of the present disclosure, in the forming of the stacking structure having the substrate including the compound semiconductor and the semiconductor layer including the light-emitting region in order from the side on which the first surface is located, the first depression is formed on at least the portion of the first edge adjacent to the second surface and the second depression is formed on the second edge extending along the thickness direction of the stacking structure. Forming the first and second depressions makes it possible to secure perpendicularity of the end surface and suppress deterioration in a threshold current, the slope efficiency, etc. Therefore, it is possible to suppress characteristic deterioration.

It is to be noted that effects of the present disclosure are not necessarily limited to those described above, and may be any of effects that are described herein.

### Brief Description of Drawings

[FIG. 1] FIG. 1 is a perspective view of an overall configuration example of a semiconductor light-emitting element according to an embodiment of the present disclosure.
[FIG. 2] FIG. 2 is a diagram illustrating a schematic configuration of the semiconductor light-emitting element illustrated in FIG. 1.
[FIG. 3] FIG. 3 is a plan view of a configuration of an element substrate before cleaving of the semiconductor light-emitting element (stacking structure) illustrated in FIG. 1.
[FIG. 4] FIG. 4 is a diagram illustrating a cross-sectional configuration of the element substrate illustrated in FIG. 3.
[FIG. 5] FIG. 5 is a flow chart illustrating a manufacturing process of the semiconductor light-emitting element illustrated in FIG. 1.
[FIG. 6A] FIG. 6A is a schematic view for description of an example of a cleaving method.
[FIG. 6B] FIG. 6B is a schematic view for description of the example of the cleaving method.
[FIG. 7] FIG. 7 is a cross-sectional view of a configuration example of a semiconductor light-emitting element according to Modification Example 1-1.
[FIG. 8] FIG. 8 is a cross-sectional view of a configuration example of a semiconductor light-emitting element according to Modification Example 1-2.
[FIG. 9] FIG. 9 is a cross-sectional view of a configuration example of a semiconductor light-emitting element according to Modification Example 1-3.
[FIG. 10] FIG. 10 is a plan view of a configuration example of a semiconductor light-emitting element according to Modification Example 2.
[FIG. 11] FIG. 11 is a diagram illustrating a cross-sectional configuration of the semiconductor light-emitting element illustrated in FIG. 10.
[FIG. 12] FIG. 12 is a cross-sectional view of a configuration example of a semiconductor light-emitting element according to Modification Example 3-1.
[FIG. 13] FIG. 13 is a cross-sectional view of a configuration example of a semiconductor light-emitting element according to Modification Example 3-2.
[FIG. 14] FIG. 14 is a cross-sectional view of a configuration example of a semiconductor light-emitting element according to Modification Example 4-1.
[FIG. 15] FIG. 15 is a cross-sectional view of a configuration example of a semiconductor light-emitting element according to Modification Example 4-2.
[FIG. 16] FIG. 16 is a cross-sectional view of a configuration example of a semiconductor light-emitting element according to Modification Example 5-1.
[FIG. 17] FIG. 17 is a cross-sectional view of a configuration example of a semiconductor light-emitting element according to Modification Example 5-2.

### Modes for Carrying Out the Invention

In the following, some embodiments of the present disclosure are described in detail with reference to the drawings. The embodiments described below each illustrate a specific example of the present disclosure, and the present disclosure is not limited to the following embodiments. Moreover, the present disclosure is not limited to positions, dimensions, dimension ratios, and other factors of respective components illustrated in the drawings. It is to be noted that description is given in the following order.
1. Embodiment (An example of a semiconductor light-emitting element having a first depression and a second depression on an edge adjacent to a second surface of a stacking structure and an edge extending in a thickness direction, respectively)
2. Modification Examples 1-1 to 1-3 (Other examples of a layout and a configuration of the first depression)
3. Modification Example 2 (Another example of a layout and a configuration of the second depression)
4. Modification Examples 3-1 and 3-2 (Other examples of a cross-sectional shape of the second depression)
5. Modification Examples 4-1 and 4-2 (Other examples of cross-sectional shapes of the first depression and a third depression)
6. Modification Examples 5-1 and 5-2 (Other configuration examples of the third depression)

### <Embodiments>

### [Configuration]

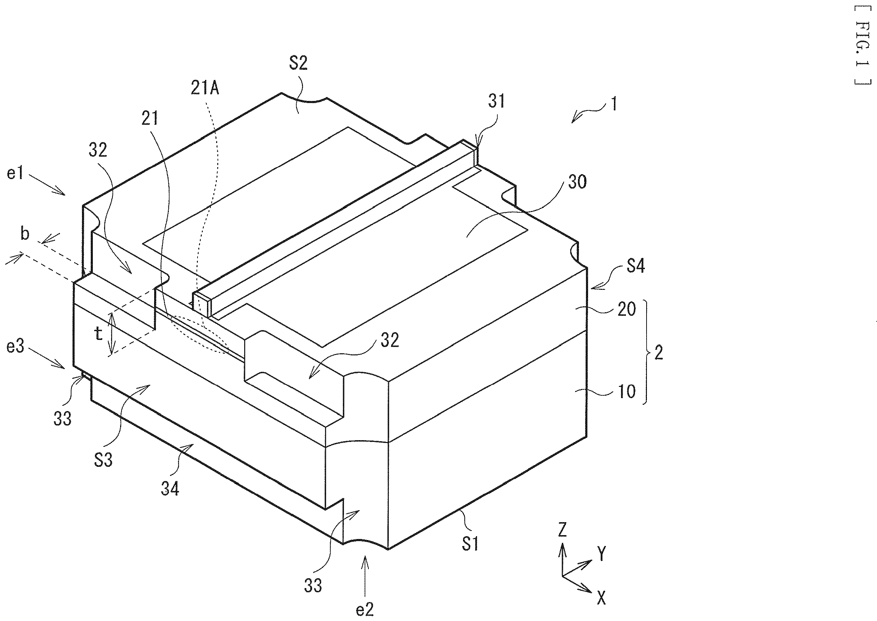

FIG. 1 illustrates a configuration example of a semiconductor light-emitting element 1 according to an embodiment of the present disclosure. The semiconductor light-emitting element 1 is preferably used as a light source for a high-density optical disk apparatus, a laser beam printer, a full-color display, etc., for example. The semiconductor light-emitting element 1 includes a stacking structure 2 having a first surface S1 and a second surface S2 facing each other. The stacking structure 2 includes, for example, a substrate 10 and a semiconductor layer 20 formed on the substrate 10 by crystal growth. A band-like projection 31 and an upper electrode 30 (for example, a p-side electrode) are provided on the second surface S2 of the stacking structure 2. An unillustrated lower electrode (for example, an n-side electrode) is electrically coupled to the substrate 10 of the stacking structure 2. The lower electrode is formed on a back surface of the first surface S1, for example.

The semiconductor light-emitting element 1 is, for example, an edge-emitting semiconductor laser, and has a pair of end surfaces S3 and S4 (a first end surface and a second end surface), with an extending direction of the projection 31 as a resonator direction (a Y direction). Note that the semiconductor light-emitting element 1 is not limited to such a semiconductor laser, and may be a semiconductor light-emitting element such as an edge-emitting light-emitting diode (LED: Light Emitting Diode) or a superluminescent diode (SLD: Superluminescent diode), for example.

The substrate 10 includes a compound semiconductor, for example, a group III-V nitride semiconductor such as GaN. Here, the "group III-V nitride semiconductor" refers to a semiconductor including at least one kind of a group of 3B group elements in the short-form periodic table and at least N of 5B group elements in the short-form periodic table. Examples of the group III-V nitride semiconductor include a gallium nitride-based compound including Ga and N. Examples of the gallium nitride-based compound include GaN, AlGaN, AlGaInN, etc. The group III-IV nitride semiconductor may be doped with an n-type impurity of a group IV or group VI element such as Si, Ge, O, or Se, or an p-type impurity of a group II or group IV element such as Mg, Zn, or C, as needed.

The substrate 10 has a semipolar surface, for example. That is, the substrate 10 has a main surface inclined at a predetermined angle (about 20 degrees or more and about 90 degrees or less, for example) in an m-axis direction from a c-plane, for example.

The semiconductor layer 20 includes a group III-V nitride semiconductor, for example, and is formed by an epitaxial crystal growth method such as an MOCVD (Metal Organic Chemical Vapor Deposition) method, for example, with the main surface of the substrate 10 as a crystal growth plane. The semiconductor layer 20 includes an active layer 21 that forms a light-emitting region 21A. Specifically, the semiconductor layer 20 has, for example, a lower cladding layer (an n-type cladding layer, for example), the active layer 21, an upper cladding layer (a p-type cladding layer, for example), and a contact layer (a p-type contact layer, for example), etc. in order from a side on which the substrate 10 is located. The lower cladding layer includes AlGaN, for example. The active layer 21 has, for example, a multiple quantum well structure including well layers and barrier layers that are alternately stacked. The well layers and the barrier layers include GaInN having mutually different composition ratios. The upper cladding layer includes AlGaN, for example. The contact layer includes GaN, for example. It is to be noted that any layer (a buffer layer, a guide layer, etc., for example) other than the foregoing layers may be further provided in the semiconductor layer 20. The upper electrode 30 is formed on the semiconductor layer 20.

The upper electrode 30 includes a laminated film including titanium (Ti), platinum (Pt), and gold (Au), for example. In contrast, the lower electrode formed on the back surface (the first surface S1) of the substrate 10 includes, for example, a laminated film including an alloy of gold (Au) and germanium (Ge), nickel (Ni), and gold (Au).

The projection 31 is a ridge including the foregoing contact layer and the foregoing upper cladding layer, for example. The projection 31 is insulated by an insulating film such as SiO₂, after the contact layer and a portion of the upper cladding layer are removed by etching.

The end surfaces S3 and S4 of the stacking structure 2 are cleaved surfaces formed by cleaving. A resonator structure is formed through sandwiching the semiconductor layer 20 between the end surfaces S3 and S4. The end surface S3 is a surface that includes the light-emitting region 21A and emits laser light. A multilayer reflection film (not illustrated) is formed on a surface of the end surface S3. The multilayer reflection film formed on the surface of the end surface S3 is a low reflection film. A reflectance adjusted by a combination of the multilayer reflection film and the end surface S3 is about 10%, for example. The end surface S4 is a surface that reflects laser light, and a multilayer reflection film (not illustrated) is also formed on a surface of the end surface S4. The multilayer reflection film formed on the surface of the end surface S4 is a high reflection film. A reflectance adjusted by a combination of the multilayer reflection film and the end surface S4 is about 95%, for example.

It is possible to form the end surfaces S3 and S4 by cleaving that utilizes a groove or a notch (a first depression 32, a second depression 33, and a third depression 34) formed by scribing.

In the present embodiment, the first depression 32 is formed on at least a portion of an edge e1 adjacent to the second surface S2 of the stacking structure 2. The second depression 33 is formed on an edge e2 extending along a thickness direction (a Z direction) of the stacking structure 2. The third depression 34 is formed on at least a portion of an edge e3 adjacent to the first surface S1 of the stacking structure 2.

Here, the stacking structure 2 has a rectangular parallelepiped shape, for example, and includes, for example, six surfaces including the first surface S1, the second surface S2, and the end surfaces S3 and S4, eight sides, and eight apexes. The edge e1 is a portion corresponding to a side adjacent to the second surface S2 and the end surface S3 and a side adjacent to the second surface S2 and the end surface S4. The edge e1 extends along an element width direction (an X direction). The edge e2 is a portion that extends along the thickness direction (the Z direction) and corresponds to one or both of two sides adjacent to the respective end surfaces S3 and S4. The edge e3 is a portion corresponding to a side adjacent to the first surface S1 and the end surface S3 and a side adjacent to the first surface S1 and the end surface S4. The edge e3 faces the edge e1, for example, and extends along the element width direction (the X direction).

The first depression 32 is formed on a portion of the edge e1, excluding a region corresponding to the light-emitting region 21A, for example. Specifically, the first depression 32 is provided on one or both of two regions sandwiching the light-emitting region 21A of the semiconductor layer 20 in between. In this example, the first depression 32 is provided on each of the two regions sandwiching the light-emitting region 21A in between. A depth t (a length along the Z direction) of the first depression 32 is 5 µm or larger and 30 µm or smaller, for example. A narrower width b (a length along the Y direction) of the first depression 32 is more favorable, and the width b of the first depression 32 is desirably 3 µm or smaller, for example. Providing the first depression 32 (a fourth depression 32A to be described later) makes it possible to concentrate stress on the first depression 32 (the fourth depression 32A) and form the end surfaces S3 and S4 with high perpendicularity during cleaving.

The second depression 33 is continuously formed from the first surface S1 to the second surface S2 on the edge e2, for example. In this example, the second depression 33 is provided on each of four edges e2 corresponding to the four sides extending in the Z direction. Providing the second depression 33 (a hole 33A to be described later) makes it possible to make a rate of crack propagation between elements constant and suppress variation in perpendicularity or flatness of the end surfaces during cleaving.

The third depression 34 continuously extends along the X direction and is provided on the edge e3, for example. A depth (a length along the Z direction) of the third depression 34 is 5 µm or larger and 30 µm or smaller, for example, and may be the same as or different from the depth of the first depression 32. Providing the third depression 34 makes it possible to improve perpendicularity of the end surfaces during cleaving.

A cross-sectional shape (an XZ cross-sectional shape) of each of the first depression 32, the second depression 33, and the third depression 34 has a quadrangular shape (a rectangular shape or square shape), for example. Corners of the quadrangular shape may be rounded. The first depression 32 and the second depression 33 of the first depression 32, the second depression 33, and the third depression 34 are provided so as to be adjacent to (connected with) each other, for example, and the third depression 34 and the second depression 33 are provided so as to be adjacent to each other, for example. Here, in a case where the first depression 32 and the second depression 33 are spaced apart, stress easily concentrates on the second depression 33. Thus, the first depression 32 and the second depression 33 are desirably provided adjacently. The width (the length along the extending direction of the edge e1 (the X direction)) of the first depression 32 is desirably larger than the width (the length along the extending direction of the edge e1 (the X direction)) of the second depression 33, which makes it possible to concentrate stress on the first depression 32 (the fourth depression 32A to be described later) rather than on the second depression 33 (the hole 33A to be described later) and form the end surfaces S3 and S4 with higher perpendicularity in cleaving.

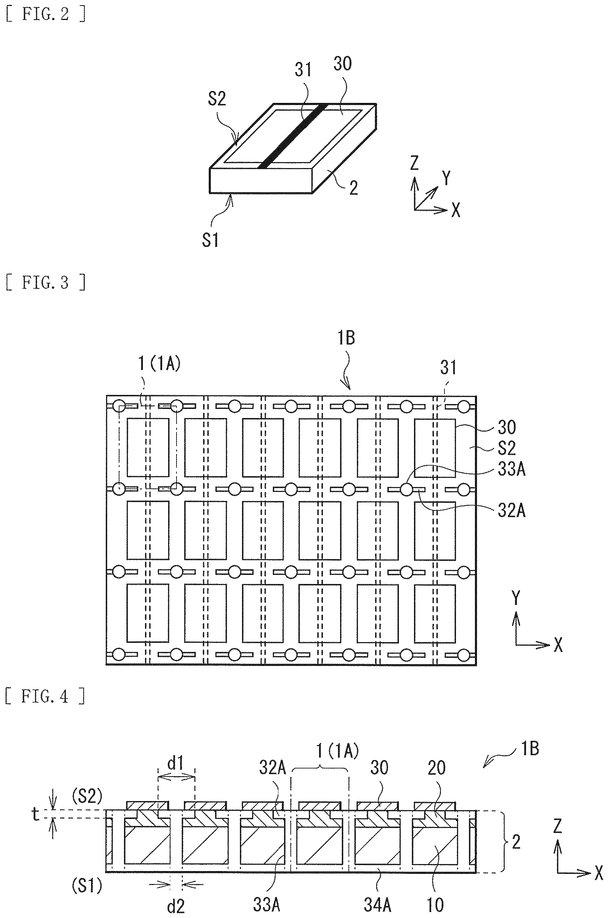

FIG. 2 illustrates a schematic configuration of the semiconductor light-emitting element 1 (the stacking structure 2). FIG. 3 schematically illustrates a planar configuration (an XY planar configuration viewed from a side on which the second surface S2 is located) before cleaving of the semiconductor light-emitting element 1. FIG. 4 illustrates a cross-sectional configuration (an XZ cross-sectional configuration) of FIG. 3. As can be seen from the above, the semiconductor light-emitting element 1 configures one (a portion of an element substrate 1B) of a plurality of element regions 1A that are two-dimensionally disposed in a state before the cleaving.

The fourth depression 32A corresponding to the foregoing first depression 32 and the hole 33A corresponding to the second depression 33 are formed on the element substrate 1B. As can be seen from the above, in the element substrate 1B before being cleaved, the fourth depression 32A and the hole 33A are provided in a region between the respective semiconductor light-emitting elements 1 (element regions 1A). Specifically, the fourth depression 32A and the hole 33A are formed in each of regions corresponding to four corners of the respective element regions 1A. In the element substrate 1B, for example, a plurality of fourth depressions 32A are formed discretely in portions excluding the projection 31 (that is, the light-emitting region 21A) and represent broken lines extending in the X direction, for example. The hole 33A is provided in a middle portion of each of the fourth depressions 32A, for example, and penetrates from the first surface S1 to the second surface S2. In contrast, a fifth depression 34A corresponding to the third depression 34 is formed on a side on which the first surface S1 is located. The fifth depression 34A is continuously formed so as to extend along the X direction.

A depth d1 (a length along the X direction) of the fourth depression 32A is desirably larger than a width (diameter) d2 (a length along the X direction) of the hole 33A. As described above, a reason for this is that it is possible to concentrate stress on the fourth depression 32A and form the end surfaces S3 and S4 with higher perpendicularity in cleaving. It is possible to form any of the fourth depression 32A, the hole 33A, and the fifth depression 34A by laser irradiation (laser scribing), for example. It is to be noted that although the laser scribing is desirable as a method of forming the fourth depression 32A, the hole 33A, and the fifth depression 34A, for example, any other method such as cutting and etching may be used.

### [Manufacturing Method]

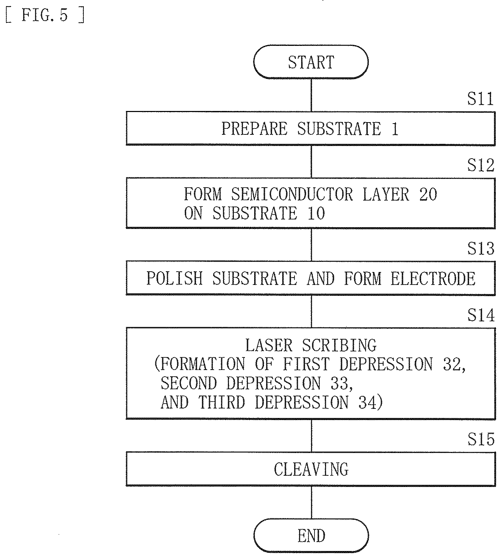

A method of manufacturing the semiconductor light-emitting element 1 is described below. FIG. 5 illustrates a flow of a manufacturing process of the semiconductor light-emitting element 1.

First, the substrate 10 including GaN, for example, is prepared as a wafer (step S11). The semiconductor layer 20 including the nitride semiconductor is formed collectively on the substrate 10 by the epitaxial crystal growth method such as the MOCVD method, for example (step S12). At this time, it is possible to use, for example, trimethyl aluminum (TMAl), trimethylgallium (TMGa), trimethyl indium (TMIn), ammonia (NH₃), etc. as a raw material of the compound semiconductor, for example, monosilane (SiH₄) as a raw material of a donor impurity, and, for example, bis(cyclopentadienyl)magnesium (Cp₂Mg) as a raw material of an acceptor impurity. Thereafter, the projection 31 is formed. Specifically, the projection 31 is formed through removing a portion of the upper cladding layer of the semiconductor layer 20 by dry etching. After the insulating film including SiO₂ or the like is formed on the projection 31, the insulating film on an upper surface of the projection 31 is removed by a photolithography method and etching.

Subsequently, the substrate 10 is polished (thinned) and the electrodes (upper electrode 30 and the lower electrode) are formed (step S13). Thus, the substrate 10 is thinned from, for example, the thickness of about 400 µm or larger and 500 µm or smaller to about 100 µm or smaller, for example. It is to be noted that the electrodes may be formed after the substrate 10 is polished, or the substrate 10 may be polished after the upper electrode 30 is formed and thereafter the lower electrode may be formed on a back surface of the substrate 10. The upper substrate 30 is formed on the second surface S2 so as to cover the projection 31.

Next, the first depression 32 (the fourth depression 32A), the second depression 33 (hole 33A), and the third depression 34 (the fifth depression 34A) are formed by laser scribing (laser irradiation), for example (step S14). Specifically, as illustrated in FIG. 3 and FIG. 4, laser light irradiation is performed while scanning the laser along the X direction on the second surface S2 of the element substrate 1B to form the fourth depression 32A. In addition, as illustrated in FIG. 3 and FIG. 4, laser light irradiation is performed while scanning the laser along the X direction on the first surface S1 of the element substrate 1B to form the fifth depression 34A. Although either the fourth depression 32A or the fifth depression 34A may be formed first, the fourth depression 32A and the fifth depression 34A are desirably formed at positions facing each other. At this time, in a case where the stacking structure 2 has transparency, it is possible to see through the stacking structure 2 and visually recognize, the fourth depression 32A (or the fifth depression 34A) that is formed first, from a side on which the first surface S1 (or the second surface S4) is located, which allows for alignment of the fourth depression 32A and the fifth depression 34A. Alternatively, it is possible to form the fourth depression 32A and the fifth depression 34A at the positions facing each other with reference to a formation pattern of the upper electrode 30 and the lower electrode formed on the element substrate 1B.

In contrast, the second depression 33 (the hole 33A) is formed, for example, after the fourth depression 32A and the fifth depression 34A are formed. However, order of forming these depressions is not particularly limited. The hole 33A may be formed before the fourth depression 32A and the fifth depression 34A are formed, or the hole 33A may be formed after the fourth depression 32A (or the fifth depression 34A) is formed and lastly the fifth depression 34A (or the fourth depression 32A) may be formed. Specifically, as illustrated in FIG. 3 and FIG. 4, it is possible to form the hole 33A penetrating through the stacking structure 2, by the laser light irradiation from a side on which the first surface S1 or the second surface S2 of the element substrate 1B is located.

A region corresponding to the fourth depression 32A and the hole 33A (a region along the extending direction of the edge e1) is a cleaving line of the element substrate 1B.

In this laser scribing, a laser that outputs a wavelength absorbable by a constituent material of the substrate 10, for example, is used. For example, in a case where a GaN substrate is used, a laser that outputs a wavelength near 350 nm is used. In addition, adjustment of laser irradiation conditions (such as power, irradiation time, and a spot diameter) makes it possible to control a width (a diameter), a depth, etc. of each of the fourth depression 32A, the fifth depression 34A, and the hole 33A.

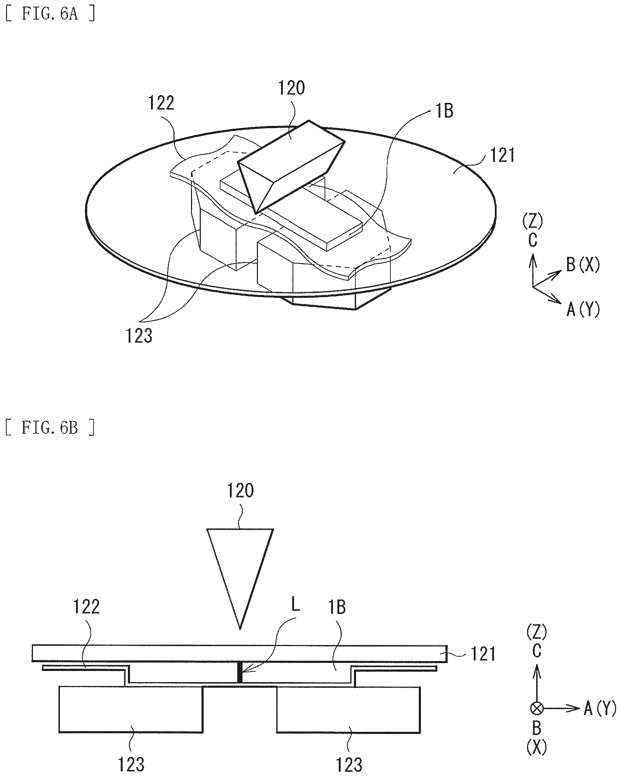

Next, cleaving is performed to form the end surfaces S3 and S4 of the stacking structure 2 and separate the semiconductor light-emitting elements 1 (element regions 1A) (Step S15). At this time, the element substrate 1B is pressed along the extending direction (the X direction) of each of the fourth depression 32A and the fifth depression 34A formed on the element substrate 1B as a cleaving line L. FIG. 6A and FIG. 6B schematically illustrate an example of a cleaving method.

As illustrated in FIG. 6A and FIG. 6B, the element substrate 1B is fixed to a surface of an adhesive sheet 121, and covered by a PET film 122 to protect the element substrate 1B. The element substrate 1B sandwiched between the adhesive sheet 121 and the PET film 122 is placed on a pair of receiving blades 123, and thereafter the element substrate 1B is pressed using a blade 120. Accordingly, the element substrate 1B is cleaved along the cleaving line L. This cleaving is repeatedly performed on respective lines along the X direction between the element regions 1A illustrated in FIG. 3.

Thus, the end surfaces S3 and S4 are formed and the plurality of semiconductor light-emitting elements 1 are obtained. The semiconductor light-emitting elements are arranged in a bar shape (arranged continuously along the X direction). After the multilayer reflection film is formed on the end surfaces S3 and S4 of the semiconductor light-emitting elements 1 arranged in the bar shape, regions between the elements along the Y direction are also scribed, and cleaved similarly as described above. The element substrate 1B is divided into the plurality of element regions 1A (the semiconductor light-emitting elements 1) in such a manner. Thus, the semiconductor light-emitting element 1 illustrated in FIG. 1 is completed.

### [Workings and Effects]

In the semiconductor light-emitting element 1 according to the present embodiment, in a case where a predetermined voltage is applied between the upper electrode 30 and the lower electrode, an electric current is injected into the active layer 21 of the semiconductor layer 20, which results in light emission by recombination of electrons and holes. Light generated in the active layer 21 is repeatedly reflected on the end surfaces S3 and S4 which configure a pair of resonator mirrors, for example, and thereafter, the light is outputted with a predetermined oscillation wavelength λ from the light-emitting region 21A on the end surface S3 (laser oscillation occurs).

In the semiconductor light-emitting element 1, the end surfaces S3 and S4 as the resonator mirrors are formed by cleaving.

However, the end surfaces formed by cleaving may not be formed perpendicularly. Poor perpendicularity of the end surfaces may cause variation in a threshold current in each of the elements or reduce substantial reflectance. Alternatively, guided wave loss occurs to deteriorate characteristics such as the threshold current or slope efficiency. In particular, in a case where the semiconductor layer is crystal-grown on a semipolar plane, and cleaving is performed as with a case where the semiconductor layer is crystal-grown on a [0001] plane, for example, perpendicularity is susceptible to an influence of the [0001] plane that is a substrate crystal plane near each of the end surfaces. Thus, the end surfaces are not formed perpendicularly, thereby causing variation in the threshold current. As can be seen from the above, poor perpendicularity of the end surfaces reduces substantial reflectance, or results in guided wave loss, thereby easily deteriorating the characteristics such as the threshold current or the slope efficiency.

It is to be noted that the foregoing PTL1, for example, proposes the method of forming a scribed hole in a wafer where a semiconductor layer is crystal-grown on a semipolar plane of a substrate, and then cleaving the wafer. The scribed hole penetrates through the wafer. However, in the scribed hole, a scribed width (a length along a resonator length direction) viewed from a P plane increases. Variation in a length along a resonator direction occurs on a cross-section of the element divided with use of such a scribed hole. In other words, perpendicularity of the end surfaces formed by cleaving degrades.

In contrast to this, in the present embodiment, the first depression 32 is formed on at least a portion of the edge e1 adjacent to the second surface S2 of the stacking structure 2, and the second depression 33 is formed on the edge e2 extending along the thickness direction of the stacking structure 2. Providing the first depression 32 and the second depression 33 makes it easy to secure perpendicularity of the end surfaces S3 and S4. Specifically, it is possible to make the rate of crack propagation between elements constant by the second depression 33 (the hole 33A) while concentrating stress in cleaving on the first depression 32 (the fourth depression 32A), which makes it easy to form the end surfaces S3 and S4 perpendicularly. Moreover, it is possible to suppress unevenness of the end surfaces S3 and S4 and enhance flatness. This makes it possible to suppress deterioration in the threshold current, the slope efficiency, etc. of the semiconductor light-emitting element 1.

Further, in the present embodiment, providing the first depression 32 and the second depression 33 makes it easy to secure linearity of the cleaving line, which makes it easier to secure perpendicularity of the end surfaces S3 and S4.

Furthermore, in the present embodiment, providing the first depression 32 and the second depression 33 makes it possible to suppress occurrence of a fine break, as compared with a case where only the first depression 32 or only the second depression 33 is provided.

In addition, in the present embodiment, flatness of the end surfaces S3 and S4 is enhanced, which makes it possible to improve ESD (Electrostatic Discharge: electrostatic discharge) resistance or COD (Catastrophic Optical Damage: optical damage) resistance.

As described above, in the present embodiment, the first depression 32 is formed on at least a portion of the edge e1 adjacent to the second surface S2 of the stacking structure 2, and the second depression 33 is formed on the edge e2 extending along the thickness direction of the stacking structure 2. This makes it possible to secure perpendicularity of the end surfaces S3 and S4 and suppress deterioration in the threshold current, the slope efficiency, etc. of the semiconductor light-emitting element 1. It is also possible to suppress characteristic variation in each of the semiconductor light-emitting elements 1. Therefore, it is possible to suppress characteristic deterioration.

Next, description is given of modification examples of the foregoing embodiment. It is to be noted that components similar to those in the foregoing embodiment are denoted by same reference numerals, and description thereof is omitted where appropriate.

### <Modification Examples 1-1 to 1-3>

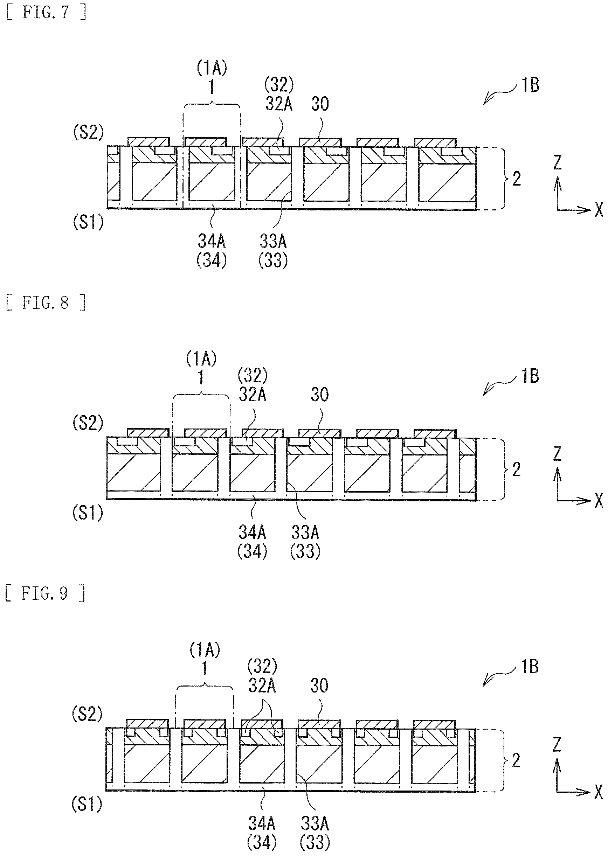

FIG. 7 is a cross-sectional view of a configuration example of a semiconductor light-emitting element according to Modification Example 1-1. FIG. 8 is a cross-sectional view of a configuration example of a semiconductor light-emitting element according to Modification Example 1-2. FIG. 9 is a cross-sectional view of a configuration example of a semiconductor light-emitting element (the element region 1A) according to Modification Example 1-3. It is to be noted that FIG. 7 to FIG. 9 illustrate a state of the element substrate 1B (a state before cleaving).

Although the foregoing embodiment exemplifies the configuration in which the first depression 32 is adjacent to the second depression 33, the first depression 32 and the second depression 33 may not be adjacent. As in Modification Examples 1-1 to 1-3, the first depression 32 and the second depression 33 may be spaced apart (so as not to overlap each other). Moreover, as in Modification Examples 1-1 and 1-2, the first depression 32 may be provided only on a portion corresponding to one side (one of two regions sandwiching the light-emitting region 21A in between) of the light-emitting region 21A (not illustrated in FIG. 7 and FIG. 8).

As can be seen from the above, a forming position of the first depression 32 and the number of first depressions 32 are not particularly limited, and it is only necessary to provide the first depression 32 on at least a portion of the edge e1 adjacent to the second surface S2 of the stacking structure 2.

### <Modification Example 2>

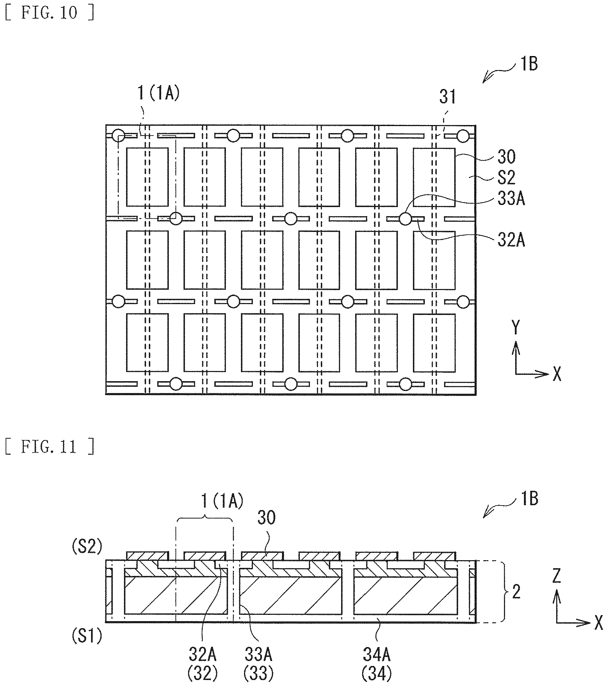

FIG. 10 is a plan view of a configuration example of a semiconductor light-emitting element according to Modification Example 2. FIG. 11 is a diagram illustrating a cross-sectional configuration of the semiconductor light-emitting element illustrated in FIG. 10. It is to be noted that FIG. 10 and FIG. 11 illustrate the state of the element substrate 1B (the state before cleaving).

Although the foregoing embodiment exemplifies the configuration in which the second depressions 33 are formed on the four edges e2 of the semiconductor light-emitting element 1 (at the four corners of the element region 1A), the second depressions 33 may be provided only on some of the four edges e2. In other words, in the element substrate 1B, a smaller number of second depressions 33 (the holes 33A) than that in the foregoing embodiment may be provided.

### <Modification Examples 3-1 and 3-2>

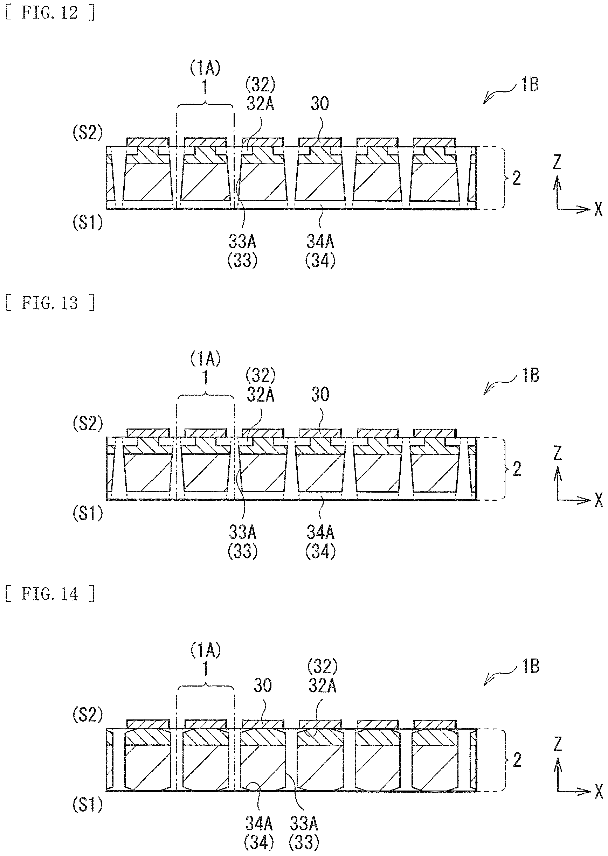

FIG. 12 is a cross-sectional view of a configuration example of a semiconductor light-emitting element according to Modification Example 3-1. FIG. 13 is a cross-sectional view of a configuration example of a semiconductor light-emitting element according to Modification Example 3-2. It is to be noted that FIG. 12 and FIG. 13 illustrate the state of the element substrate 1B (the state before cleaving).

Although the foregoing embodiment exemplifies the case where the cross-sectional shape of the second depression 33 is the rectangular shape or the square shape, the cross-sectional shape of the second depression 33 is not limited thereto, and may be a trapezoidal shape or a triangular shape as in Modification Examples 3-1 and 3-2. In this case, in the element substrate 1B, as illustrated in FIG. 12 and FIG. 13, the second depression 33 (the hole 33A) is formed so as to have a diameter (a width) that gradually increases from the first surface S1 to the second surface S2. Laser light irradiation is performed in laser scribing while gradually increasing (or reducing) laser output to form one hole 33A, which makes it possible to form such a shape.

### <Modification Examples 4-1 and 4-2>

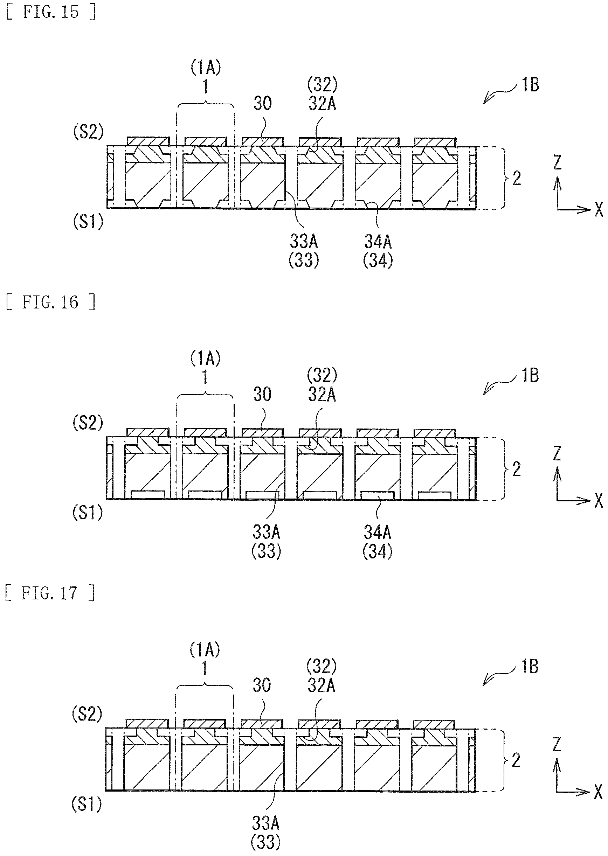

FIG. 14 is a cross-sectional view of a configuration example of a semiconductor light-emitting element according to Modification Example 4-1. FIG. 15 is a cross-sectional view of a configuration example of a semiconductor light-emitting element according to Modification Example 4-2. It is to be noted that FIG. 14 and FIG. 15 illustrate the state of the element substrate 1B (the state before cleaving).

Although the foregoing embodiment exemplifies the case where the cross-sectional shapes of the first depression 32 and the third depression 34 are the rectangular shape or the square shape, the cross-sectional shapes of the first depression 32 and the third depression 34 are not limited thereto, and may be a trapezoidal shape or a triangular shape, as in Modification Examples 4-1 and 4-2. In other words, the first depression 32 and the third depression 34 may have a tapered shape (an inclined surface). Moreover, although not illustrated specifically, the respective cross-sectional shapes of the first depression 32 and the third depression 34 may be the same or different.

### <Modification Examples 5-1 and 5-2>

FIG. 16 is a cross-sectional view of a configuration example of a semiconductor light-emitting element according to Modification Example 5-1. FIG. 17 is a cross-sectional view of a configuration example of a semiconductor light-emitting element according to Modification Example 5-2. It is to be noted that FIG. 16 and FIG. 17 illustrate the state of the element substrate 1B (state before cleaving).

Although the foregoing embodiment exemplifies the configuration in which the third depression 34 is provided continuously along the extending direction of the edge e3 on the side on which the first surface S1 is located, the third depression 34 may be provided only in a selective region of the edge e3, as in Modification Example 5-1. In this case, as illustrated in FIG. 16, in the element substrate 1B, a plurality of third depressions 34 are discretely formed along the extending direction of the edge e3. Moreover, although the third depression 34 is spaced apart from the second depression 33 in the example in FIG. 16, the third depression 34 may be provided adjacent to the second depression 33.

Further, as in Modification Example 5-2, the third depression 34 may not be provided. As long as the first depression 32 and the second depression 33 are provided, it is possible to secure perpendicularity of the end surfaces S3 and S4.

Although the description has been given by referring to the embodiment and the modification examples, the present disclosure is not limited to the foregoing embodiment, etc., and may be modified in a variety of ways. It is to be noted that the effects described herein are merely illustrative. The effects of the present disclosure are not limited to those described herein. The present disclosure may further have any effects other than those described herein. In any case, the invention is defined by the appended independent claims. Optional features are further defined by the dependent claims.

It should be understood that those skilled in the art could conceive various modifications, combinations, sub-combinations, and alterations depending on design requirements and other factors, insofar as they are within the scope of the appended claims.

## Claims

1. A semiconductor light-emitting element (1), comprising:
a stacking structure (2) having a substrate (10) and a semiconductor layer (20) between a first surface (S1) and a second surface (S2) that face each other in order from a side on which the first surface (S1) is located, the substrate (10) including a compound semiconductor, and the semiconductor layer (20) being crystal-grown on the substrate (10) and including a light-emitting region (21A);
a first depression (32) formed on at least a portion of a first edge (e1) adjacent to the second surface (S2) of the stacking structure (2), and wherein the first depression (32) is formed on a portion of the first edge (e1), excluding a region corresponding to the light-emitting region (21A); and
a second depression (33) formed on a second edge (e2) extending along a thickness direction of the stacking structure (2),
**characterised in that**
the second depression is provided as a quarter-circular recess continuously formed from the first surface (S1) to the second surface (S2), part of a hole (33A) penetrating the stacking structure upon fabrication.

2. The semiconductor light-emitting element (1) according to claim 1, further comprising a third depression (34) on at least a portion of a third edge (e3) that is adjacent to the first surface (S1) of the stacking structure (2) and faces the first edge.

3. The semiconductor light-emitting element (1) according to claim 1, wherein a length of the first depression (32) along an extending direction of the first edge (e 1) is larger than a length of the second depression (33) along the extending direction of the first edge (e 1).

4. The semiconductor light-emitting element (1) according to claim 1, wherein
the first depression (32) is provided on one or both of two regions sandwiching the light-emitting region (21A) of the semiconductor layer (20) in between, or
the first depression (32) is provided adjacent to the second depression (33), or
the first depression (32) is spaced apart from the second depression (33).

5. The semiconductor light-emitting element (1) according to claim 1, wherein a cross-sectional shape of each of the first (32) and second (33) depressions is a square shape, a triangular shape, or a trapezoidal shape.

6. The semiconductor light-emitting element (1) according to claim 1, wherein
the stacking structure (2) has a rectangular parallelepiped shape, and has a first end surface including the light-emitting region (21A) and a second end surface facing the first end surface, and
the first edge (e1) is a portion corresponding to each of a side adjacent to the second surface (S2) and the first end surface, and a side adjacent to the second surface (S2) and the second end surface.

7. The semiconductor light-emitting element (1) according to claim 1, wherein
the stacking structure (2) has a rectangular parallelepiped shape, and has a first end surface including the light-emitting region (21A) and a second end surface facing the first end surface, and
the second edge (e2) extends along the thickness direction, and is a portion corresponding to one or both of two sides adjacent to each of the first and second end surfaces.

8. The semiconductor light-emitting element (1) according to claim 2, wherein
the stacking structure (2) has a rectangular parallelepiped shape, and has a first end surface including the light-emitting region (21A) and a second end surface facing the first end surface, and
the third edge (e3) is a portion corresponding to each of a side adjacent to the first surface (S1) and the first end surface and a side adjacent to the first surface (S1) and the second end surface.

9. The semiconductor light-emitting element (1) according to claim 1, wherein the substrate (10) has a semipolar plane.

10. The semiconductor light-emitting element (1) according to claim 1, wherein the stacking structure (2) includes a group III nitride semiconductor.

11. A method of manufacturing the semiconductor light-emitting element (1) according to claim 1, the method comprising:
forming a stacking structure (2) having a substrate (10) and a semiconductor layer (20) between a first surface (S1) and a second surface (S2) that face each other in order from a side on which the first surface (S1) is located, the substrate (10) including a compound semiconductor, and the semiconductor layer (20) being crystal-grown on the substrate (10) and including a light-emitting region,
the forming of the stacking structure (2) including
forming a first depression (32) on at least a portion of a first edge (e1) adj acent to the second surface (S2) of the stacking structure, and wherein the first depression (32) is formed on a portion of the first edge, excluding a region corresponding to the light-emitting region, and
forming a second depression (33) on a second edge (e2) extending along a thickness direction of the stacking structure (2), wherein the second depression is provided as part of hole (33) upon fabrication.

12. The method according to claim 11, wherein
a plurality of element regions each corresponding to the stacking structure (2) are formed on the substrate, and thereafter an end surface of the stacking structure (2) is formed by cleaving, and
the cleaving includes
forming a fourth depression (32A) extending along one direction on at least a portion of regions between respective element regions of the second surface (S2),
forming a hole (33A) penetrating through the stacking structure (2) on at least a portion of regions between the respective element regions, and
forming the end surface with use of a region corresponding to the fourth depression (32A) and the hole (33A) as a cleaving line.

13. The method according to claim 12, wherein the fourth depression (32A) and the hole (33A) are each formed by laser irradiation.

## Patentansprüche

1. Halbleiter-Lichtemissionselement (1), umfassend:
eine Stapelstruktur (2), die ein Substrat (10) und eine Halbleiterschicht (20) zwischen einer ersten Oberfläche (S1) und einer zweiten Oberfläche (S2) aufweist, die einander der Reihe von einer Seite aus gegenüberliegen, auf der sich die erste Oberfläche (S1) befindet, wobei das Substrat (10) einen Verbindungshalbleiter einschließt und die Halbleiterschicht (20) auf dem Substrat (10) kristallgezüchtet ist und einen Lichtemissionsbereich (21A) einschließt;
eine erste Vertiefung (32), die auf mindestens einem Abschnitt einer ersten Kante (e1) angrenzend an die zweite Oberfläche (S2) der Stapelstruktur (2) ausgebildet ist, und wobei die erste Vertiefung (32) auf einem Abschnitt der ersten Kante (e1) ausgebildet ist, mit Ausnahme eines Bereichs, der dem Lichtemissionsbereich (21A) entspricht; und
eine zweite Vertiefung (33), die auf einer zweiten Kante (e2) ausgebildet ist, die sich entlang einer Dickenrichtung der Stapelstruktur (2) erstreckt,
**dadurch gekennzeichnet, dass**
die zweite Vertiefung als eine viertelkreisförmige Aussparung ausgebildet ist, die von der ersten Oberfläche (S1) bis zu der zweiten Oberfläche (S2) durchgehend ausgebildet ist und Teil eines Lochs (33A) ist, das bei einer Produktion die Stapelstruktur durchdringt.

2. Halbleiter-Lichtemissionselement (1) nach Anspruch 1, ferner umfassend eine dritte Vertiefung (34) auf mindestens einem Abschnitt einer dritten Kante (e3), die an die erste Oberfläche (S1) der Stapelstruktur (2) angrenzt und der ersten Kante zugewandt ist.

3. Halbleiter-Lichtemissionselement (1) nach Anspruch 1, wobei eine Länge der ersten Vertiefung (32) entlang einer Erstreckungsrichtung der ersten Kante (e1) größer als eine Länge der zweiten Vertiefung (33) entlang der Erstreckungsrichtung der ersten Kante (e1) ist.

4. Halbleiter-Lichtemissionselement (1) nach Anspruch 1, wobei
die erste Vertiefung (32) in einem oder beiden von zwei Bereichen bereitgestellt ist, die den Lichtemissionsbereich (21A) der Halbleiterschicht (20) dazwischen einfassen, oder
die erste Vertiefung (32) angrenzend an die zweite Vertiefung (33) bereitgestellt ist, oder
die erste Vertiefung (32) von der zweiten Vertiefung (33) beabstandet ist.

5. Halbleiter-Lichtemissionselement (1) nach Anspruch 1, wobei eine Querschnittsform jeder der ersten (32) und der zweiten (33) Vertiefung eine Quadratform, eine Dreiecksform oder eine Trapezform ist.

6. Halbleiter-Lichtemissionselement (1) nach Anspruch 1, wobei
die Stapelstruktur (2) eine rechteckige Parallelepipedform aufweist und eine erste Endoberfläche, die den Lichtemissionsbereich (21A) einschließt, und eine zweite Endoberfläche aufweist, die der ersten Endoberfläche zugewandt ist, und
die erste Kante (e1) ein Abschnitt ist, der jeder einer Seite, die an die zweite Oberfläche (S2) und die erste Endoberfläche angrenzt, und einer Seite entspricht, die an die zweite Oberfläche (S2) und die zweite Endoberfläche angrenzt.

7. Halbleiter-Lichtemissionselement (1) nach Anspruch 1, wobei
die Stapelstruktur (2) eine rechteckige Parallelepipedform aufweist und eine erste Endoberfläche, die den Lichtemissionsbereich (21A) einschließt, und eine zweite Endoberfläche aufweist, die der ersten Endoberfläche zugewandt ist, und
sich die zweite Kante (e2) entlang der Dickenrichtung erstreckt und ein Abschnitt ist, der einer oder beiden von zwei Seiten entspricht, die an jede der ersten und der zweiten Endoberfläche angrenzen.

8. Halbleiter-Lichtemissionselement (1) nach Anspruch 2, wobei
die Stapelstruktur (2) eine rechteckige Parallelepipedform aufweist und eine erste Endoberfläche, die den Lichtemissionsbereich (21A) einschließt, und eine zweite Endoberfläche aufweist, die der ersten Endoberfläche zugewandt ist, und
die dritte Kante (e3) ein Abschnitt ist, der jeder einer Seite, die an die erste Oberfläche (S1) und die erste Endoberfläche angrenzt, und einer Seite entspricht, die an die erste Oberfläche (S1) und die zweite Endoberfläche angrenzt.

9. Halbleiter-Lichtemissionselement (1) nach Anspruch 1, wobei das Substrat (10) eine semipolare Ebene aufweist.

10. Halbleiter-Lichtemissionselement (1) nach Anspruch 1, wobei die Stapelstruktur (2) einen Nitridhalbleiter der Gruppe III einschließt.

11. Verfahren zum Herstellen des Halbleiter-Lichtemissionselements (1) nach Anspruch 1, das Verfahren umfassend:
Ausbilden einer Stapelstruktur (2), die ein Substrat (10) und eine Halbleiterschicht (20) zwischen einer ersten Oberfläche (S1) und einer zweiten Oberfläche (S2) aufweist, die einander der Reihe von einer Seite aus gegenüberliegen, auf der sich die erste Oberfläche (S1) befindet, wobei das Substrat (10) einen Verbindungshalbleiter einschließt und die Halbleiterschicht (20) auf dem Substrat (10) kristallgezüchtet ist und einen Lichtemissionsbereich einschließt,
das Ausbilden der Stapelstruktur (2) einschließlich
Ausbilden einer ersten Vertiefung (32) auf mindestens einem Teil einer ersten Kante (e1) angrenzend an die zweite Oberfläche (S2) der Stapelstruktur, und wobei die erste Vertiefung (32) auf einem Abschnitt der ersten Kante ausgebildet ist, mit Ausnahme eines Bereichs, der dem Lichtemissionsbereich entspricht; und
Ausbilden einer zweiten Vertiefung (33) auf einer zweiten Kante (e2), die sich entlang einer Dickenrichtung der Stapelstruktur (2) erstreckt, wobei die zweite Vertiefung bei der Produktion als Teil des Lochs (33) bereitgestellt ist.

12. Verfahren nach Anspruch 11, wobei
eine Vielzahl von Elementbereichen, die jeweils der Stapelstruktur (2) entsprechen, auf dem Substrat ausgebildet ist, und danach eine Endoberfläche der Stapelstruktur (2) durch ein Spalten ausgebildet wird, und
das Spalten einschließt
Ausbilden einer vierten Vertiefung (32A), die sich entlang einer Richtung auf mindestens einem Abschnitt der Bereiche zwischen jeweiligen Elementbereichen der zweiten Oberfläche (S2) erstreckt,
Ausbilden eines Lochs (33A), das die Stapelstruktur (2) durchdringt, auf mindestens einem Abschnitt der Bereiche zwischen den jeweiligen Elementbereichen, und
Ausbilden der Endoberfläche unter Verwendung eines Bereichs, der der vierten Vertiefung (32A) und dem Loch (33A) entspricht, als eine Spaltlinie.

13. Verfahren nach Anspruch 12, wobei die vierte Vertiefung (32A) und das Loch (33A) jeweils durch eine Laserbestrahlung ausgebildet sind.

## Revendications

1. Élément émetteur de lumière à semi-conducteur (1), comprenant :
une structure d'empilement (2) ayant un substrat (10) et une couche semi-conductrice (20) entre une première surface (S1) et une seconde surface (S2) qui se font face l'une l'autre dans l'ordre à partir d'un côté sur lequel la première surface (S1) est localisée, le substrat (10) comportant un semi-conducteur composé, et la couche semi-conductrice (20) étant soumise à une croissance de cristaux sur le substrat (10) et comportant une région émettrice de lumière (21A) ;
une première dépression (32) formée sur au moins une portion d'un premier bord (e1) adjacent à la seconde surface (S2) de la structure d'empilement (2), et dans lequel la première dépression (32) est formée sur une portion du premier bord (e1), à l'exclusion d'une région correspondant à la région émettrice de lumière (21A) ; et
une deuxième dépression (33) formée sur un deuxième bord (e2) s'étendant le long d'une direction d'épaisseur de la structure d'empilement (2),
**caractérisé en ce que**
la deuxième dépression est fournie en tant qu'évidement en quart de cercle formé de façon continue de la première surface (S1) à la seconde surface (S2), partie d'un trou (33A) pénétrant la structure d'empilement à la fabrication.

2. Élément émetteur de lumière à semi-conducteur (1) selon la revendication 1, comprenant en outre une troisième dépression (34) sur au moins une portion d'un troisième bord (e3) qui est adjacent à la première surface (S1) de la structure d'empilement (2) et fait face au premier bord.

3. Élément émetteur de lumière à semi-conducteur (1) selon la revendication 1, dans lequel une longueur de la première dépression (32) le long d'une direction d'extension du premier bord (e1) est plus grande qu'une longueur de la deuxième dépression (33) le long de la direction d'extension du premier bord (e1).

4. Élément émetteur de lumière à semi-conducteur (1) selon la revendication 1, dans lequel
la première dépression (32) est fournie sur l'une et/ou l'autre de deux régions intercalant la région émettrice de lumière (21A) de la couche semi-conductrice (20) entre elles, ou
la première dépression (32) est fournie adjacente à la deuxième dépression (33), ou
la première dépression (32) est espacée de la deuxième dépression (33).

5. Élément émetteur de lumière à semi-conducteur (1) selon la revendication 1, dans lequel une forme en coupe transversale de chacune des première (32) et deuxième (33) dépressions est une forme carrée, une forme triangulaire ou une forme trapézoïdale.

6. Élément émetteur de lumière à semi-conducteur (1) selon la revendication 1, dans lequel
la structure d'empilement (2) a une forme de parallélépipède rectangle, et a une première surface d'extrémité comportant la région émettrice de lumière (21A) et une seconde surface d'extrémité faisant face à la première surface d'extrémité, et
le premier bord (e1) est une portion correspondant à chacun parmi un côté adjacent à la seconde surface (S2) et à la première surface d'extrémité, et un côté adjacent à la seconde surface (S2) et à la seconde surface d'extrémité.

7. Élément émetteur de lumière à semi-conducteur (1) selon la revendication 1, dans lequel
la structure d'empilement (2) a une forme de parallélépipède rectangle, et a une première surface d'extrémité comportant la région émettrice de lumière (21A) et une seconde surface d'extrémité faisant face à la première surface d'extrémité, et
le deuxième bord (e2) s'étend le long de la direction d'épaisseur, et est une portion correspondant à l'un et/ou l'autre de deux côtés adjacents à chacune des première et seconde surfaces d'extrémité.

8. Élément émetteur de lumière à semi-conducteur (1) selon la revendication 2, dans lequel
la structure d'empilement (2) a une forme de parallélépipède rectangle, et a une première surface d'extrémité comportant la région émettrice de lumière (21A) et une seconde surface d'extrémité faisant face à la première surface d'extrémité, et
le troisième bord (e3) est une portion correspondant à chacun parmi un côté adjacent à la première surface (S1) et à la première surface d'extrémité et un côté adjacent à la première surface (S1) et à la seconde surface d'extrémité.

9. Élément émetteur de lumière à semi-conducteur (1) selon la revendication 1, dans lequel le substrat (10) a un plan semi-polaire.

10. Élément émetteur de lumière à semi-conducteur (1) selon la revendication 1, dans lequel la structure d'empilement (2) comporte un semi-conducteur au nitrure du groupe III.

11. Procédé de fabrication de l'élément émetteur de lumière à semi-conducteur (1) selon la revendication 1, le procédé comprenant :
la formation d'une structure d'empilement (2) ayant un substrat (10) et une couche semi-conductrice (20) entre une première surface (S1) et une seconde surface (S2) qui se font face l'une l'autre dans l'ordre à partir d'un côté sur lequel la première surface (S1) est localisée, le substrat (10) comportant un semi-conducteur composé, et la couche semi-conductrice (20) étant soumise à une croissance de cristaux sur le substrat (10) et comportant une région émettrice de lumière,
la formation de la structure d'empilement (2) comportant
la formation d'une première dépression (32) sur au moins une portion d'un premier bord (e1) adjacent à la seconde surface (S2) de la structure d'empilement, et dans lequel la première dépression (32) est formée sur une portion du premier bord, à l'exclusion d'une région correspondant à la région émettrice de lumière, et
la formation d'une deuxième dépression (33) sur un deuxième bord (e2) s'étendant le long d'une direction d'épaisseur de la structure d'empilement (2), dans lequel la deuxième dépression est fournie en tant que partie d'un trou (33) à la fabrication.

12. Procédé selon la revendication 11, dans lequel
une pluralité de régions d'élément correspondant chacune à la structure d'empilement (2) sont formées sur le substrat, et par la suite une surface d'extrémité de la structure d'empilement (2) est formée par clivage, et
le clivage comporte
la formation d'une quatrième dépression (32A) s'étendant le long d'une direction sur au moins une partie de régions entre des régions d'élément respectives de la seconde surface (S2).
la formation d'un trou (33A) pénétrant à travers la structure d'empilement (2) sur au moins une partie de régions entre les régions d'élément respectives, et
la formation de la surface d'extrémité avec l'utilisation d'une région correspondant à la quatrième dépression (32A) et le trou (33A) en guise de ligne de clivage.

13. Procédé selon la revendication 12, dans lequel la quatrième dépression (32A) et le trou (33A) sont formés chacun par irradiation laser.
